# EUROPEAN PATENT APPLICATION

(11) **EP 0 903 935 A1**
(43) Date of publication of application: **24.03.1999**
(21) Application number: 97870169.6
(22) Date of filing: 24.10.1997
(51) Int. Cl.: H04N 3/15

(54) **Method for obtaining a high dynamic range read-out signal of a CMOS-based pixel structure and such CMOS-based pixel structure**

(30) Priority: 22.09.1997 EP 97870142
(71) Applicant: INTERUNIVERSITAIR MICRO-ELEKTRONICA CENTRUM VZW, 3001 Heverlee (BE)
(72) Inventor: Dierckx, Bart, 2640 Mortsel (BE); Scheffer, Danny, 4567 DG Clinge (NL)
(74) Representative: Van Malderen, Joelle

(57) **Abstract**

A method for obtaining a read-out signal of a CMOS-based pixel structure having at least a photosensitive element with an output node and a memory element with a first switch therebetween is disclosed. The method comprises the steps of while acquiring charge carriers on said output node of said photosensitive element, said charge carriers being converted from electromagnetic radiation on the photosensitive element, after a first time period opening said first switch thereby storing a first number of said charge carriers on said memory element and creating a first signal, after a second time period, closing said first switch and thereafter opening said first switch, thereby storing a second number of said charge carriers on said memory element and thereby creating a second signal, said read-out signal being a combination of at least said first and said second signals.

## Description

### Field of the invention

The present invention relates to solid state imaging devices being manufactured in a CMOS- or MOS-technology. More particularly, the present invention is related to a method of obtaining a read-out signal of a CMOS-based pixel structure with a large dynamic range.

The present invention is also related to a new pixel structure and to imaging devices having such pixel structure involved in the method of the present invention.

### Background of the invention and problem definition

Solid state imaging devices are well known. These devices find a widespread use in camera systems. In such application, a matrix of pixels comprising light sensitive elements constitutes an image sensor, which is mounted in the camera system. The signal of said matrix is measured and multiplexed to a video-signal.

Commonly solid state image devices are implemented in a CCD-technology or in a CMOS- or MOS-technology.

Among the image sensors implemented in a CMOS- or MOS-technology, CMOS or MOS image sensors with passive pixels and CMOS or MOS image sensors with active pixels are distinguished. An active pixel is configured with means integrated in the pixel to amplify the charge that is collected on the light sensitive element. Passive pixels do not have said means and require a charge-sensitive amplifier that is not integrated in the pixel and is connected with a long line towards the pixel.

There is an ongoing effort to increase the performance of CMOS or MOS image sensors such that a comparable image quality is obtained as the one obtained with high end CCD imagers. Due to the miniaturisation of the technology of CMOS based electronic circuits, it is further possible to realise complex CMOS- or MOS-based pixels as small as CCD-based pixels. It is a main advantage of CMOS- or MOS-based image sensors that CMOS technology is being offered by most foundries whereas CCD-technology is rarely offered and a more complex and expensive technology option.

In the co-pending patent applications EP-A-0773667 and EP-97870084.7 pixel structures and methods of addressing them are described which yield, alone or in combination, the above-mentioned goals. The contents of these patent applications are incorporated herein by reference.

In general, it must be recognised that for an imaging device, three specifications that are difficult to match are to be met:
- the sensitivity of the image device, especially in the dark,
- the cosmetic quality of the image (this means that the image should be flawless), and
- the requirement of a response with a high dynamic range.

Image sensors having a non-linear response such as a logarithmic response are known from, e.g. EP-A-0739039.

However, most of the image sensors with passive or active pixels show a linear voltage-to-light response. This means that their dynamic range is limited by the dynamic range of the linear response. For instance, if the linear output voltage has an S/R ratio of about 250 (which is a typical value) the corresponding dynamic range will be the same.

Image sensors with a double linear response or multiple linear response are known. In such sensors, two or more linear pieces of optical response are combined in one electrical output signal, outside the pixel. Presently, the classical image sensors can be used to obtain such double linear response image by capturing two images with different sensitivity and combining them.

### Aims of the invention

The present invention aims to disclose an active or passive pixel structure such that with one single pixel, a double or multiple linear, voltage-to-light response can be obtained. The present invention further aims to disclose a method of reading out an active or passive pixel structure such that a double or multiple linear voltage-to-light response can be obtained in one single image scan.

### Main characteristics of the present invention

A method for obtaining a read-out signal of a CMOS-based pixel structure having at least a photosensitive element with an output node and a memory element with a first switch therebetween is disclosed. The method comprises the steps of while acquiring charge carriers on said output node of said photosensitive element, said charge carriers being converted from electromagnetic radiation on the photosensitive element, after a first time period opening said first switch thereby storing a first number of said charge carriers on said memory element and creating a first signal; after a second time period, closing said first switch and thereafter opening said first switch thereby storing a second number of said charge carriers on said memory element and thereby creating a second signal, said read-out signal being a combination of at least said first and said second signals.

The photosensitive element can be any element such as a photodiode, a photogate, a CCD-cell, a phototransistor or a photoresistor.

The above-mentioned steps and/or concept can be repeated for a number of time periods being larger than 2.

According to a first preferred embodiment, the read-out signal is an average or a weighed average of at least said first and said second signals.

According to another preferred embodiment, the read-out signal is a subtraction of said second signal and said first signal.

According to a preferred embodiment, a correlated double-sampling is performed using an extra-step of closing a second switch which is placed in series with the photosensitive element in order to have a reset of said photosensitive element and thereby creating a third signal, said read-out signal being a combination of first, second and third signals.

Preferably, in this case the read-out signal is a combination of the subtraction of third and first signals and subtraction of third and second signals.

According to another preferred embodiment, the read-out signal can be a combination of the subtraction of second and first signals and subtraction of third and second signals.

According to another preferred embodiment of the present invention, the read-out signal can be a combination of the subtraction of second and first signals and subtraction of third and first signals.

The present invention is also related to a CMOS based pixel structure comprising at least:
- a photosensitive element for converting electromagnetic radiation into charge carriers and being connected to a reset switch and to a supply voltage;
- a memory element being connected to an amplifier, and
- a first switch in-between said photosensitive element and said memory element, said first switch being opened causing a first number of said charge carriers being stored on said memory element.

The memory element is preferably an analog memory element such as a capacitor and the switches present in the pixel structure as well as the memory element are preferably CMOS transistors. The capacitor can be in fact a parasitic capacitor being formed by the interconnect lines in the pixel.

The present invention is also related to a CMOS image device having a geometric configuration of pixel, each of the pixels having the structure described hereabove.

### Brief description of the figures

- Figure 1a and 1b: show is a schematic functional representation of the pixel structure according to embodiments of the present invention.
- Figure 2a and 2b: represent the architecture of a pixel according to specific embodiments of the present invention.
- Figure 3a: represents a typical response of the pixel f figure 2.
- Figure 3b: represents the different possibilities for the slope of the response being varying by the electronic shutter ratio.
- Figure 4: represents a possible embodiment of the pixel structure according to the present invention.
- Figure 5: represents a method of driving and reading the pixel.

### Description of preferred emodiments of the Present invention

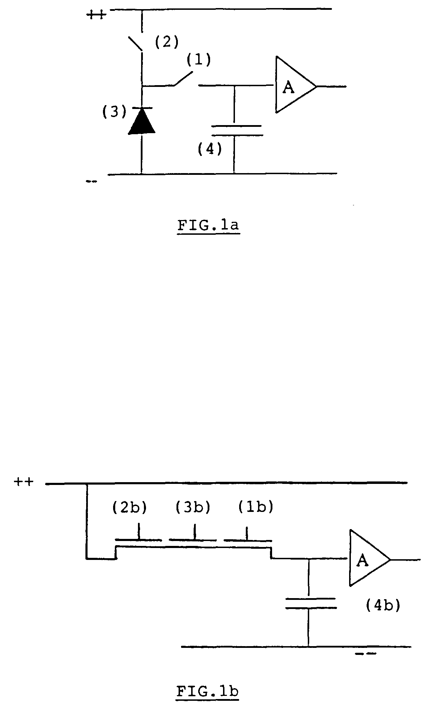

Figure 1 represents a functional pixel structure according to an embodiment of the invention wherein a memory element (4) is provided. In this figure 1, (3) is a photosensitive element such as a photoreceptor or photodiode, which can be reset by a switch (2). The signal required on the photodiode can be periodically sampled by another switch (1) on a capacitor (4). The resulting voltage can then be multiplexed in a classical way over circuitry represented by the amplifier A.

According to one preferred embodiment, such amplifier A is placed within the pixel structure in order to have an active pixel. According to another preferred embodiment, the amplifier A can be placed outside of the pixel structure in order to have a passive pixel structure.

This pixel structure is able to perform the method of the invention for obtaining a read-out signal as described and therefore is able to realise a double or multiple linear light-to-voltage response in one single pixel.

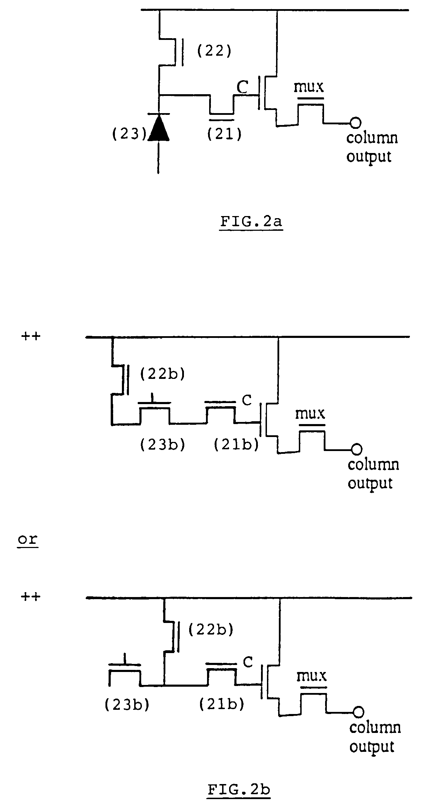

The figure 2 represents a specific embodiment of the schematic structure as represented in Figure 1. The pixel therein is a 4T (transistor) integrating active pixel. It has the feature of being able to sample through switch (21) a signal level intermediate in the integration slope, on the node C. Afterwards, both signals (the intermediate value and the final integrated value) can be combined in one read-out signal with high dynamic. In the simplest approach, this combination consists of adding both values.

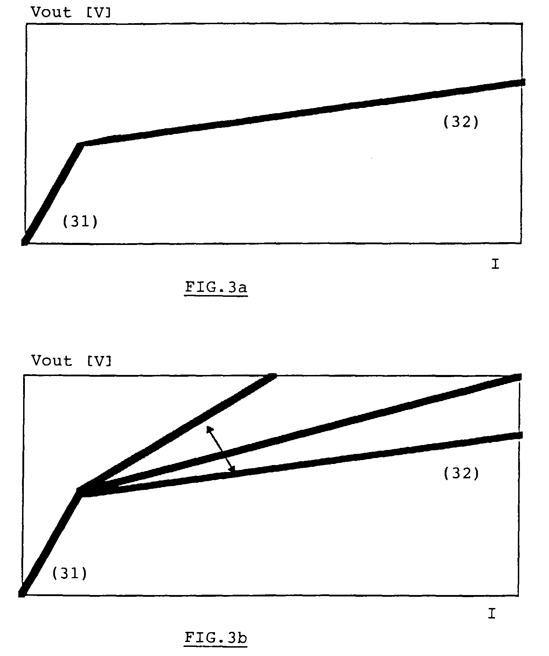

The effective response of such a structure is represented in Figure 3a for an active pixel with a double linear slope having a first (32) and a second (31) part. According to the present invention and as represented in Figure 3b, the slope of the first part (32) can be varied by the electronic shutter ratio according to the number of rows in the image. For instance, between a factor of 1 to 250.

The double slope compresses the high intensity part of an image, but preserves the low intensity part. It has a comparable property as the gamma correction or as the logarithmic compression, yet it can be tuned within a wide range to accommodate various light intensity conditions.

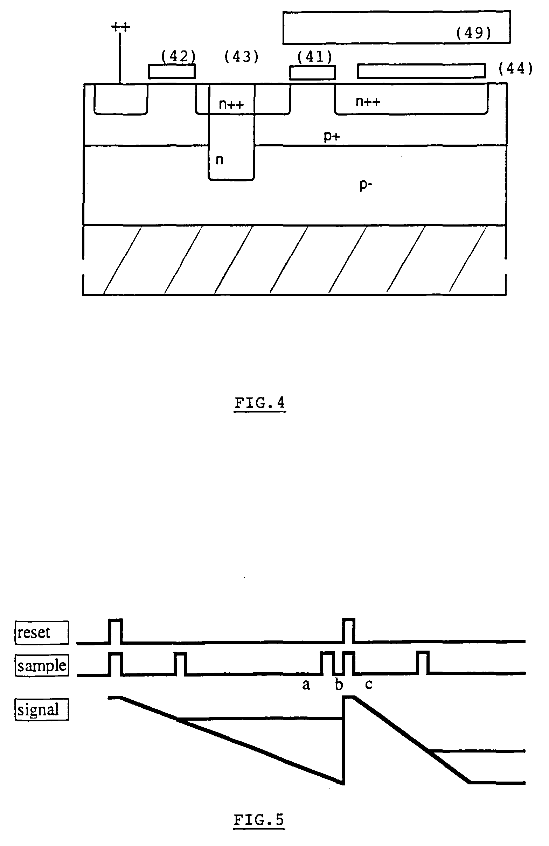

A cross-section of a possible implementation in a CMOS technology of a pixel structure as represented in Figure 1 or 2 is shown in Figure 4 wherein the memory element is also realised as a MOS structure (44) (although it is not necessary to do so); the amplification and multiplexing beyond are not shown. The metal light shield (49) is not necessary, as the operation of the pixel structure tolerates some charge collection. Further shown in figure 4 is a silicon substrate wherein a photosensitive element (43) as a (n⁺⁺)n/p- junction; a first switch (41) and a second switch (42) as metal or polysilicon layers separated from the silicon substrate in fact from (the p⁺ surface layer) by a dielectric layer.

The analog memory element is represented by the capacitor component (44) which has a part or parts which are junctions, or which has connections to other circuit elements (in casu transistors) which have junctions. Junctions are light sensitive, and this light sensitivity will cause a current flow which will affect the charge stored on; the capacitor (44). Such memory element or capacitor (44) can be used for various purposes : spatial and temporal filtering, the memorisation of image, etc.

The above circuit should, in order to operate in the best mode, have a stable signal on capacitor (44) Hereto, the capacitor and also the interconnections to it should be shielded from the light, which is straightforward by using a metallisation. However, the capacitor and/or interconnection elements to it may also collect charge that is present in the chip's substrate due to light falling on it. Especially, photo charge that is being created deep in the substrate can diffuse easily onto capacitor (44) or its interconnections, and (dis-)charge them.

If the photo diode (43) or another diode, not part of the capacitor (44) is made according to the embodiment of Figure 4, the wandering charge in the substrate of the chip will likely be collected there, and will thus not affect the charge on the capacitor (44)

The present invention is also related to preferred methods of reading the signal of a CMOS based pixel structure in order to obtain a double or multiple linear slope for a dynamic response. According to the first preferred embodiment, as represented in Figure 5, several pulses can be applied to the reset and (22) and to the switch (21) of the pixel structure of figure 2. On Figure 5, the reset is represented on the

first line, the sample on the second and the potential level seen on the photodiode output node and on the node C on the third line.

Two integration periods are shown on Figure 5. A certain time after the reset pulse, the switch (21) is opened for a short while, thus freezing this potential on the node (capacitor) C. At the end of the first integration period, the switch (21) is shortly opened, and the recent potential on the photodiode output node is sampled.

In the present embodiment, a weighted average of the recent potential on the photodiode output node and of the potential that was frozen on the capacitor C is sampled (signal "b") . After reset (closing of switch 22), the reset level of the pixel is sampled again (signal "c") which might be useful for offset correction, correlated double sampling etc. This signal sample ("b") is sufficient to obtain a double linear response, as this sample is in itself the average of the potential on capacitor C and on the photodiode, which are the electrical responses with low and high sensitivity themselves. Difference (b-c) is a correlated double sampled version of this signal thus removing eventual offset non-uniformity.

In a more general teaching and without reference to the pixel structure of figure 2, in figure 5, the method of the invention is schematically shown.

On Figure 5, the reset is represented on the first line, the sample on the second and the potential level seen on the photodiode output node and on the node C on the third line. A certain time after the reset pulse, the sample is opened for a short while, thus freezing this potential on capacitor C.

At the end of the integration period, the memorized value on the capacitor C is sampled ("a"), then the sample switch is shortly opened, and the recent potential on the photodiode output node is sampled ("b"). After reset, the reset value of the pixel is sampled, which might be useful for offset correction, correlated double sampling etc.

Values a and b, or in a correlated double sampling configuration, (c-a) and (c-b) are the responses with low and high responsivity respectively. Both values can be combined externally to the pixel, inside or outside the image sensor. The simple way of combination is a linear combination, yielding effective response curves as shown in figure 3.

Values a and b, or in a correlated double sampling configuration (c-a) and (c-b) are the responses with low and high responsivity respectively. Both values can be combined externally to the pixel, inside or outside to the image sensor. A simple way of combination is a linear or even non linear combination, yielding an effective response curve as shown in figure 3a.

In an embodiment of the present invention, a pixel structure is made in a 0.7 µm CMOS technology and fabricated at MITEC. The pixel of the invention shows a dynamic range of about 1:20000 to 1:60000 whereas a reference pixel without the characteristics of the invention and fabricated in the same technology shows a dynamic range of about 1:2000 to 1:3000.

## Claims

1. A method for obtaining a read-out signal of a CMOS-based pixel structure having at least a photosensitive element with an output node and a memory element with a first switch therebetween, the method comprising the steps of:
- while acquiring charge carriers on said output node of said photosensitive element, said charge carriers being converted from electromagnetic radiation on the photosensitive element;
- after a first time period opening said first switch thereby storing a first number of said charge carriers on said memory element and creating a first signal;
- after a second time period, closing said first switch and thereafter opening said first switch thereby storing a second number of said charge carriers on said memory element and thereby creating a second signal;
- said read-out signal being a combination of at least said first and said second signals.

2. The method as recited in claim 1, wherein said steps are repeated for a number of time periods being larger than 2.

3. The method as recited in claim 1, wherein the read-out signal is an average of at least said first and said second signals.

4. The method as recited in claim 1, wherein the read-out signal is a linear combination of said second signal and said first signal.

5. The method as recited in claim 1, wherein a correlated double-sampling is performed using an extra-step of closing a reset switch which is placed in series with the photosensitive element in order to have a reset of said photosensitive element and thereby creating a third signal, said read-out signal being a combination of said first, second and third signals.

6. The method as recited in claim 5, wherein the read-out signal is a combination of the subtraction of third and first signals and of the subtraction of third and second signals.

7. The method as recited in claim 5, wherein the read-out signal is a combination of the subtraction of second and first signals and of the subtraction of third and second signals.

8. The method as recited in claim 5, wherein the read-out signal is a combination of the subtraction of second and first signals and of the subtraction of third and first signals.

9. A CMOS-based pixel structure, comprising at least:
- a photosensitive element for converting electromagnetic radiation into charge carriers, and being connected to a reset switch and to a supply voltage;
- a memory element being connected to an amplifier; and
- a first switch in-between said photosensitive element and said memory element, said first switch being opened causing a first number of said charge carriers being stored on said memory element.

10. A CMOS-based pixel structure according to claim 9, wherein the memory element is an analog memory such as a capacitor or a parasitic capacitor.

11. A CMOS-based pixel structure according to claim 9, wherein both switches are CMOS transistors.

12. A CMOS-based pixel structure according to any one of the preceding claims 9 to 11, wherein said amplifier is placed within the pixel structure in order to have an active pixel.

13. A CMOS-based pixel structure according to any one of the preceding claims 9 to 12, wherein said amplifier is placed outside of the pixel structure in order to have a passive pixel structure.

14. A CMOS image sensor having a geometric configuration of pixels consisting in a structure according to any one of the claims 9 to 12.

15. Use of the CMOS image sensor as recited in claim 14 or of the method as recited in claim 1 in a camera system.
